# EUROPEAN PATENT APPLICATION

(11) **EP 3 940 123 A1**
(43) Date of publication of application: **19.01.2022**
(21) Application number: 20770583.1
(22) Date of filing: 18.02.2020
(51) Int. Cl.: C30B 25/18, H01L 21/20, H01L 21/205, H01L 21/265, C30B 29/38

(54) **NITRIDE SEMICONDUCTOR SUBSTRATE**

(30) Priority: 13.03.2019 JP 2019070218
(71) Applicant: Texas Instruments Incorporated, Dallas, Texas 75265 (US)
(72) Inventor: TAKAMIZAWA Shoichi, takasaki-shi Gunma 370-0045 (JP)
(74) Representative: Zeller, Andreas
(86) International application number: PCT/JP2020/006306
(87) International publication number: WO 2020/184091

(57) **Abstract**

[Problem]

When a nitride semiconductor layer is epitaxially grown on a silicon single crystal substrate, distortions occur due to lattice mismatch and difference in the thermal expansion coefficient and large warpage and cracks occur, which disturbs device production. Another problem is that a nitride semiconductor with good crystallinity cannot be obtained.

[Solution]

Distortion due to lattice mismatch generated during epitaxial growth of a nitride semiconductor onto a silicon single crystal substrate, and thermal distortion due to difference in the thermal expansion coefficient occurring during the cooling process after epitaxial growth of the nitride semiconductor are mitigated not only by a buffer layer in the nitride semiconductor, but also by a misfit dislocation layer formed in the silicon single crystal substrate in parallel to the surface thereof. This achieves a nitride semiconductor substrate having excellent crystallinity without the occurrence of cracks or large warpage.

## Description

### TECHNICAL FIELD

The present invention relates to a silicon substrate for fabricating a nitride semiconductor substrate represented by, for example, a GaN on Si wafer, where a nitride semiconductor is epitaxially grown on a silicon single crystal substrate (hereinafter expressed as a silicon substrate), and relates to a semiconductor substrate, where a nitride semiconductor is epitaxially grown on this substrate.

### BACKGROUND

Nitride single crystal is widely used in the form of a semiconductor substrate in which a nitride semiconductor is epitaxially grown on an inexpensive silicon substrate or on a sapphire substrate, because nitride single crystal is extreme difficulty to grow from a liquid phase. However, when a nitride semiconductor layer is grown thick on a silicon substrate or a sapphire substrate, stress occurs due to differences in lattice constant and the coefficient of thermal expansion, resulting in dislocations and warpage. Particularly when a silicon substrate is used, there is a problem in that dislocation density in the nitride semiconductor layer becomes high, which deteriorates electrical properties of the device. In addition, there are problems in that the warpage of the substrate becomes larger, which would inhibit wafer processing in a semiconductor apparatus, and cracks occur in the nitride semiconductor epitaxial layer.

As a measure for addressing the problem of the warpage of a substrate, a method of increasing the thickness of a silicon substrate is introduced in Patent Document 1. A thick substrate with a thickness of up to about 1 mm is used, which can reduce warpage and can be handled in fabrication lines in device fabrication. Also introduced is a method of suppressing the increase in warpage, by doping the silicon substrate with an impurity to a high concentration to harden the substrate by the impurity curing.

Furthermore, Patent Document 2 discloses a method of suppressing the generation of warpage and the generation of cracks, by applying a thin film of a material whose coefficient of thermal expansion is smaller than that of silicon, onto the back surface of a silicon substrate. However, there is a problem in that slipping dislocation would be generated when a large thermal stress is applied to a silicon substrate at a high temperature. Therefore, the range of the suppression of the generation of cracks by reducing the warpage of the nitride semiconductor substrate would be limited at a low temperature.

When a nitride semiconductor is to be epitaxially grown on a silicon substrate, a method widely used is to form a buffer layer in a nitride semiconductor layer that can mitigate lattice mismatch between the substrate and the epitaxial layer by introducing misfit dislocations while effectively suppressing the propagation of the dislocations toward the surface, and to epitaxially grow gallium nitride. The buffer layer has another role of mitigating thermal stresses caused due to the difference in the coefficient of thermal expansion between the nitride semiconductor and the silicon crystal in cooling down to the room temperature after the epitaxial growth. These two roles of the buffer layer are not currently mutually compatible.

### PRIOR ART DOCUMENTS

### PATENT DOCUMENTS

Patent Document 1: Japanese Patent Laid-Open No. 2014-192246
Patent Document 2: Japanese Patent Laid-Open No. 2010-272781

### NON-PATENT DOCUMENTS

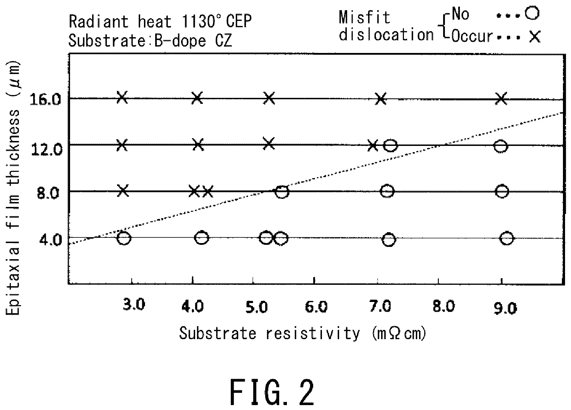

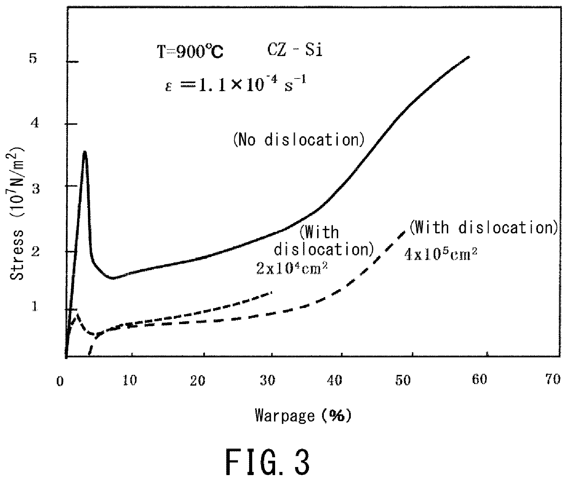

Non-Patent Document 1: Takao Abe, "Silicon" (Crystal Growth and Wafer Processing), Baifukan, (1994), pp17, FIG. 2.5 and pp.45 FIG. 3.22
Non-Patent Document 2: Yoshimitsu Sugita, Journal of the Crystallographic Society of Japan, 12, (1970), pp. 100

### SUMMARY OF THE INVENTION

### PROBLEMS TO BE SOLVED BY THE INVENTION

As described above, when a nitride semiconductor is to be epitaxially grown on a silicon substrate, several approaches have been proposed to improve large stresses generated in an interface between the epitaxial layer and the silicon substrate due to the lattice constant mismatch or the difference in the coefficient of thermal expansion, and resulting warpage. However, when a silicon substrate is to be used as a substrate for epitaxially growing a nitride semiconductor, the generation of warpage has been more problematic than a case where a sapphire substrate is used. Furthermore, the dislocation density in the nitride semiconductor layer surface is about one order of magnitude higher than a case where a sapphire substrate is used. Silicon substrates are thus not yet widely used.

The reason why it is desired to use silicon wafers as a substrate for epitaxially growing a nitride semiconductor is to increase the diameter of the substrates for cost reduction. Sapphire substrates are mostly two inches or three inches in diameter, whereas silicon substrates are mostly six inches. However, as the diameter of the wafer increases, it becomes much more difficult to solve the problem of warpage. If the warpage of the wafer becomes larger, problems arise in that the apparatus would not be able to process the wafer in device fabrication steps, and cracks would be generated.

Since the difference in lattice constant between gallium nitride and silicon is quite large, epitaxial growth of gallium nitride is performed after a buffer layer is formed. Inside the buffer layer, lattice distortion is mitigated by the introduction of a high density of misfit dislocations. Most of the misfit dislocations are edge-like dislocations that extend parallel to the epitaxial interface, and thus dislocations extending toward the surface are limited. Various efforts have been made so that the misfit dislocations do not extend toward the surface, by a nitride buffer layer whose composition of gallium or aluminum is steeply altered periodically, or a nitride buffer layer whose group III element composition is graded. The buffer layer mitigates not only lattice distortion, but also mitigates thermal distortion, which is caused due to differences in the coefficient of thermal expansion during cooling after the epitaxial growth, by its misfit dislocations.

It is desirable that the buffer layer is excellent in its ability of suppressing the generation of warpage due to the difference in the coefficient of thermal expansion that occurs during cooling to the room temperature after the epitaxial growth. This is because device fabrication becomes impossible if the warpage of the wafer becomes greater. Another reason is because, when cracks occur in the nitride semiconductor layer, the occurrence of the cracks in turn generates foreign matters, and thus process yield would be significantly reduced. In a sapphire substrate where cracks and warpage are less likely to occur, the role of the buffer layer in mitigating thermal distortion is reduced. As a result, the use of a sapphire substrate will lower the dislocation density in the nitride semiconductor in a region where the device is to be formed by about one order of magnitude, compared to a case where a silicon substrate is used.

One reason why it is desired to use a silicon wafer as a substrate for epitaxially growing a nitride semiconductor is a goal of finding a way to practical use of high-performance high voltage transistors by utilizing superior properties of gallium nitride. Although the practical use of such transistors has begun, a full solution of the problems associated with the crystal quality, such as current collapse, is still awaited. In addition to addressing the problem of warpage, improvements in crystallinity of the nitride semiconductor layer are also expected. Although some attempts have been made to fabricate LEDs using GaN on Si wafers, the dislocation density in gallium nitride crystal is high and its emission efficiency is low, and thus the advantages in using large-diameter wafers have not been exploited and silicon wafers have not yet surpassed sapphire substrates.

In the epitaxial wafers in which a nitride semiconductor is grown on a sapphire substrate that are widely used for LEDs, compressive stress exerts on a nitride semiconductor film after cooling, because the nitride semiconductor has a coefficient of thermal expansion 15% smaller than that of sapphire. Therefore, cracks are unlikely to occur. Since small diameter substrates of two to three inches are widely used, warpage is smaller and rarely causes concern. Therefore, buffer layers can be optimized such that the density of threading dislocations that extend toward the surface would not increase, placing emphasis on the mitigation of lattice distortion.

In contrast, when a nitride semiconductor is to be epitaxially grown on a silicon substrate, the generation of warpage and the generation of cracks due to tensile stress become problematic, because the nitride semiconductor has a coefficient of thermal expansion 60% or more greater than that of the silicon. It is required to mitigate lattice distortion, while giving a higher priority to the mitigation of thermal distortion occurring during cooling to the room temperature. Therefore, it is required to introduce a high density of misfit dislocations in the buffer layer, which in turn increases the density of threading dislocations extending toward a top portion of the buffer layer.

### MEANS FOR SOLVING THE PROBLEM

The following discussion is directed to a wafer, in which gallium nitride crystal is epitaxially grown on a silicon substrate, so-called GaN on Si.

Conventionally, in fabrication of nitride semiconductor substrates, distortions associated with the mismatch in lattice constant between silicon crystal and gallium nitride crystal and thermal distortions due to the difference in thermal conductivity occurring at the time of cooling after the epitaxial growth are mitigated by a buffer layer, which is made of nitride aluminum, gallium nitride and a mixed crystal of them, formed in the gallium nitride. The present invention is characterized in that these two types of distortions described above are mitigated also from the silicon substrate, which enables to reduce the density of threading dislocations in a gallium nitride layer on the buffer layer, and to fabricate a gallium nitride substrate in which cracks are not generated and large warpage does not occur.

In order to improve the quality of crystallinity of a gallium nitride layer epitaxially grown on a silicon substrate while preventing the generation of cracks and large warpage, the inventor devised a method for fabricating a gallium nitride epitaxial wafer with small warpage and good crystallinity, by causing misfit dislocations in the silicon substrate to mitigate lattice distortion occurring in the interface with the silicon substrate when the gallium nitride is epitaxially grown, also from the silicon side, and to mitigate thermal stresses caused due to the difference in the coefficient of thermal expansion in cooling down to the room temperature after the epitaxial growth.

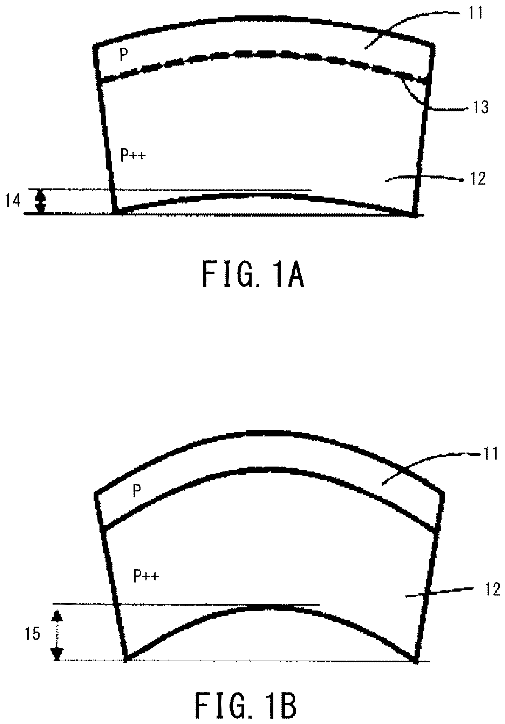

When a non-doped silicon epitaxial layer, or a silicon epitaxial layer to which boron, phosphorus, or arsenic is doped to a concentration of 1 × 10¹⁸ atoms/cc or less is epitaxially grown on a polished silicon wafer to which boron or phosphorus having a small covalent radius is doped to a concentration of 1×10¹⁹ atoms/cc or more, lattice mismatch occurs in an interface between the polished wafer and the epitaxial layer, and thus the shape of the silicon epitaxial wafer becomes convex. If a polished silicon wafer to which arsenic or antimony having a large covalent radius is doped to a high concentration is used, then the shape of the wafer becomes concave. The thicker the epitaxial layer becomes, the stress increases and the greater the warpage becomes. It is also well known in the art of the epitaxial fabrication of silicon that, when a silicon epitaxial film having a high resistivity is grown thick onto a silicon substrate having a low resistivity, misfit dislocations occur and stresses are mitigated, and warpage due to plastic deformation would be almost halved. (FIG. 1)

Single crystal silicon does not exhibit plasticity at the room temperature. Single crystal silicon, which is dislocation-free even at a high temperature, elastically deforms. However, when stress of a certain magnitude or greater is applied, dislocation is introduced and plastic deformation will occur therein. Crystal orientation and the state of stress will determine the types of dislocations generated and the direction they extend to. When the epitaxial growth interface is a (111) plane, the misfit dislocations that mitigate lattice mismatch are mainly edge-like dislocations extending parallel to the growth interface. In a region where dislocations occur, plastic deformation easily occurs. It is known that such phenomena become apparent at a temperature above 800 °C in silicon. FIG. 3 illustrates a schematic diagram of stress distortion curves at a temperature of 900 °C for silicon dislocation-free crystal and crystal with dislocations.

### (See Non-Patent Document 1)

When a nitride semiconductor is epitaxially grown on a silicon substrate, misfit dislocations occur immediately in an early stage of the growth because lattice mismatch is extremely large. A buffer layer is formed such that stresses are kept parallel to the growth interface, and then a gallium nitride crystal, on which a device is to be formed after the lattice mismatch is mitigated to some extent, is grown thereon. When mitigation of lattice mismatch is in progress in the buffer layer, some of dislocations become threading dislocations that extend toward the surface layer. Various designs of the structure of the buffer layer have been made in order to reduce the density of the threading dislocations.

However, compared with a case where a sapphire substrate is used, the use of a silicon substrate increases the density of threading dislocations in gallium nitride crystal about one order of magnitude, and thus gallium nitride crystal is rarely used for LEDs. It is considered that this is mostly because that the ratio of the coefficient of thermal expansion of sapphire with respect to that of gallium nitride is 1.16, whereas the ratio of the coefficient of thermal expansion of silicon with respect to that of gallium nitride is 0.6, and thus there would be a large difference in thermal stresses that occur during cooling after the epitaxial growth. Among the properties of the buffer layer of the nitride semiconductor, priority would be given for mitigation of thermal stresses when a silicon substrate is used. In the present method, misfit dislocations in the silicon substrate also contribute to the mitigation of thermal stresses and thus the generation of cracks and warpage is suppressed, and therefore a buffer layer that causes less threading dislocations can be used.

In silicon power MOSFETs, misfit dislocations may become threading dislocations due to distortion during device fabrication, and may extend into device regions, which may lead to an increase in leakage current. Therefore, techniques that can suppress the generation of misfit dislocations have been studied. It is also known that misfit dislocations in close proximity to each other can cause interactions with each other, resulting in threading dislocations that extend toward the surface. (Non-Patent Document 2) After the epitaxial growth of gallium nitride is performed at a temperature range of 1050 °C to 1150 °C, the effects on the misfit dislocations of thermal distortion caused during the cooling to room temperature are complex. The effect of stress mitigation is reduced when the misfit dislocations intentionally introduced into the silicon substrate are spaced more than 100 µm away from the nitride semiconductor buffer layer. However, the range of closeness that would cause an interaction between dislocations and then increase threading dislocations is an issue to be determined individually, partly because of the relationship with the method used to fabricate the nitride buffer layer.

It can be seen from FIG. 3 that plastic deformation is less likely to occur in a silicon substrate where dislocation did not occur. A larger stress is applied to the buffer layer of the nitride semiconductor accordingly, and thus a higher density of misfit dislocations would be generated to mitigate the stress. Since the dislocation density becomes higher, there would be a greater likelihood that dislocations cross each other to become threading dislocations. It is thus considered that the density of dislocations that extend upward of the buffer layer becomes higher.

There are several methods for causing misfit dislocations in a silicon epitaxial wafer. The following discussion is mainly directed to a method that uses an ultralow resistant polished silicon wafer, which is relatively easily obtained and easily fabricated, as a substrate.

When a high resistant thick epitaxial film is grown on a very low resistant silicon substrate, misfit dislocations may occur. Various measures have been studied to avoid the occurrence. In contrast, however, in the present method, conditions for the substrate and epitaxial growth need to be determined in order to cause misfit dislocations.

In general, the impurity concentration of the polished silicon substrate described above is 1×10¹⁹ atoms/cm³ or more, and the impurity concentration of the epitaxial layer is 2×10¹⁸ atoms/cm³ or less. When an epitaxial film doped to a low concentration (high resistant) is grown on a polished silicon substrate to which phosphorus or boron is doped to a high concentration (low resistant), lattice mismatch of an order of 0.01% occurs at the interface (Non-Patent Document 2), and a convex warpage occurs on the surface. When an epitaxial film doped to a low concentration (high resistant) is grown on a low resistant substrate to which arsenic or antimony is doped to a high concentration, a concave warpage occurs on the surface. As the high resistant epitaxial growth advances at a high temperature and the epitaxial layer becomes thicker, the stress occurring due to the mismatch in lattice constant between the epitaxial layer and the substrate increases and the warpage of the wafer becomes greater. When the epitaxial film thickness exceeds a critical film thickness, a misfit dislocation occurs and the stress is mitigated by plastic deformation, which reduces warpage. (FIG. 1)

Whether or not misfit dislocations occur depends on the temperature of the epitaxial growth (heat treatment temperature) of silicon, the resistivity of the substrate, and the thickness of the epitaxial layer. (See FIG. 2) The substrate in which misfit occurs can be observed and evaluated by x-ray topography, as introduced in Non-Patent Document 1. Even when such a technique is not used, misfits can be visually observed, if they exist in a wide range, as mesh-like steps on the surface under a condensing lamp.

In the present invention, in addition to the method in which the concentration of dopants in the polished silicon wafer is increased in order to form misfit dislocations in the silicon epitaxial wafer, a layer to which boron or phosphorus is doped to a high concentration may be formed in the silicon epitaxial layer. One or more thin silicon germanium layers may be inserted into the epitaxial layer.

Alternatively, rather than a low resistant polished silicon wafer or forming an epitaxial layer with a high concentration in the epitaxial substrate, a nitride semiconductor may be epitaxially grown on a silicon substrate, in which one or more species of phosphorus, boron, antimony, carbon, or germanium have been ion implanted at a dose of 5× 10¹⁴ atoms/cm² or more, and a recovery heat treatment has been performed, and then silicon epitaxial growth has been performed and misfit dislocations have been introduced.

### EFFECTS OF THE INVENTION

As described above, according to the present invention, when a nitride semiconductor is to be epitaxially grown on a silicon substrate, a silicon substrate, in which misfit dislocations are intentionally generated so that plastic deformation is likely to occur therein, is used. Therefore, stresses caused due to lattice mismatch occurring at an interface with the silicon substrate when the nitride semiconductor epitaxially grows can be mitigated not only by a buffer layer formed in the nitride semiconductor, but can be mitigated also by the silicon substrate. As a result, a nitride semiconductor crystal layer having a good crystallinity and with a low warpage can be formed on a silicon crystal.

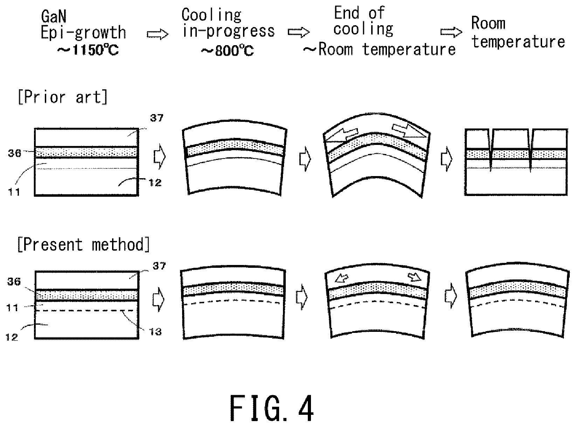

When the nitride semiconductor crystal is cooled down to the room temperature after it is epitaxially grown on the silicon crystal, a large concave warpage occurs due to the difference in thermal conductivity between silicon and the nitride semiconductor, and sometimes cracks may occur in the nitride semiconductor layer. As shown in FIG. 4, by forming misfit dislocations in the silicon epitaxial wafer that serves as a substrate, thermal stress occurring during the cooling down to about 800 °C is mitigated also in the silicon substrate due to plastic deformation. Thermal stress when it is cooled down to the room temperature thus becomes small, and the generation of warpage and cracks can be prevented.

### BRIEF DESCRIPTION OF THE DRAWINGS

FIG. 1 schematically illustrates a case where an epi-layer becomes thick as the epitaxial growth proceeds and misfit dislocations occur, and a state of the warpage immediately before the occurrence.
FIG. 2 is a drawing representing the relation among the epitaxial layer thickness of the silicon epitaxial wafer, the resistivity of the substrate, and the generation of misfit dislocations with the growth at 1130 °C.
FIG. 3 illustrates stress vs. distortion curves for dislocation-free silicon crystal and silicon crystal with dislocations at 900 °C. (Tensile distortion added.)
FIG. 4 illustrates states of stress in steps of cooling a nitride semiconductor in a case where there are misfit dislocations in the epitaxial substrate of the present invention, and a case without misfit dislocation.
FIG. 5 schematically illustrates a semiconductor apparatus in which a semiconductor substrate of the present invention is used.

### DETAILED DESCRIPTION OF THE EMBODIMENTS

A standard method for fabricating a GaN on Si substrate is described below. Depending on the equipment used, conditions herein may not be optimal. The best mode is described on the assumption that a GaN on Si wafer for HEMT is fabricated using a heater-type single wafer MOCVD apparatus.

FIG. 1 illustrates a (P/P++ type) silicon epitaxial wafer in which an epitaxial layer of several Qcm is formed on at an extremely low resistant p-type substrate. The substrate is a CZ substrate with a crystal orientation (111) of 150 mmϕ and doped with boron in a range of 2-4×10¹⁹ atoms/cm³. Epitaxial growth was performed in a single wafer reactor to grow an epitaxial layer by using trichlorosilane as a silicon source. The epitaxial layer is doped with boron with a concentration of 1-2×10¹⁶ atoms/cm³. FIG. 1A illustrates an epitaxial wafer, to which epitaxial growth is performed to a thickness of 6 µm at 1200 °C and misfit dislocations (MFD) occurred therein. FIG. 1B illustrates an epitaxial wafer, to which epitaxial growth is performed to a thickness of 4 µm at 1120 °C and no misfit occurred therein.

In all the epitaxial wafers in FIG. 1A, mesh-like minute steps intersecting at 60° generated due to misfit dislocations were visually observed under a condensing lamp. A portion of the wafer was examined through x-ray topography, and it was found that misfit dislocations occurred therein. Warpage was 14 µm or less.

For the epitaxial wafers in FIG. 1B, any mesh-like minute steps that are intersecting at 60° generated due to misfit dislocations were not visually observed under a condensing lamp. One of the wafers was extracted and examined through x-ray topography, but generation of any misfit dislocation was not observed. Warpage was around 22 µm.

Next, a step of creating a GaN on Si wafer is described, in which a nitride semiconductor is epitaxially grown on the silicon epitaxial substrate by using an MOCVD apparatus. For the MOCVD apparatus, a single wafer type, experimental reactor was used. The silicon epitaxial substrate was pre-annealed in a hydrogen atmosphere at 1120 °C, and then an initial layer was formed by growing an AlN film to a thickness of 100 nm using TMA (trimethylaluminum) and NH₃ (ammonia) gases.

A buffer layer was then formed on the initial layer. The buffer layer was grown by repeating a first layer and a second layer, several tens of times to one hundred and several tens of times. The first layer is made of AlN and having a thickness of about 5 nm, and the second layer is made of GaN and having a thickness of about 5 nm grown by using TMG (trimethylgallium) and NH₃ (ammonia) gases. In this example, the thickness of the buffer layer was set to be 1000 nm.

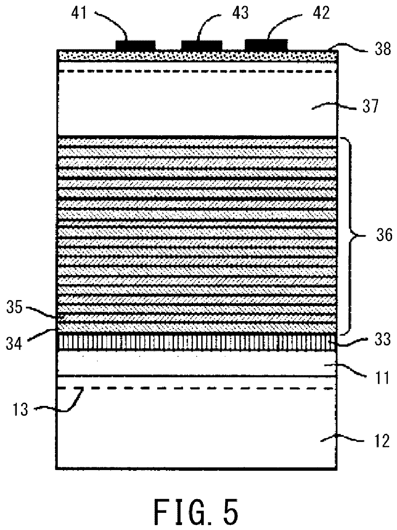

Following the growth of the buffer layer, a gallium nitride layer (iGaN layer) was grown on the buffer layer. During the growth of the gallium nitride layer, which is called an active layer, impurity is not doped. In this case, a GaN on Si wafer whose gallium nitride layer has a thickness of 2.5 µm was created. On the gallium nitride layer, a barrier layer made of AlGaN (Al-composition 0.25) was formed. The thickness of the barrier layer is 25 nm. By using the fabrication method described above, a GaN on Si wafer to be used as a substrate for an HEMT device having a structure shown in FIG. 5 was fabricated.

Embodiments having different conditions are described below by using the basic fabrication method described above as a basis, but the present invention is not limited thereto.

### (Embodiment 1)

As a silicon substrate, the epitaxial substrate shown in FIG. 1A in which misfit dislocations occurred was used. After pre-annealing in a hydrogen atmosphere at 1120 °C, an initial layer of AlN was formed to a thickness of 100 nm without changing the temperature, and then a buffer layer was grown successively. The total thickness of the buffer layer is 1000 nm. A gallium nitride layer, which is an active layer, was grown on the buffer layer at 1120 °C to a thickness of 2500 nm. Among the GaN on Si substrates fabricated by such methods, the crystal quality of GaN layers (iGaN layer and AlGaN layer) were evaluated in terms of a full width at half maximum (arcsec) of the peak waveform by an x-ray diffraction method (XRD). Results were: the full width at half maximum of the (102) plane was 399 arcsec, and the full width at half maximum of the (002) plane was 318 arcsec. No crack was observed on the entire surface of this GaN on Si wafer.

### (Embodiment 2)

As a silicon substrate, the epitaxial substrate shown in FIG. lAin which misfit dislocations occurred was used. After pre-annealing in a hydrogen atmosphere at 1120 °C, the epitaxial layer was etched by 2µm using HCI gas to a thickness of 4µm, and then processed similarly to the case as in Embodiment 1 to obtain GaN on Si wafers. Among the GaN on Si wafers obtained, GaN layers (iGaN layer and AlGaN layer) were evaluated by an x-ray diffraction method. Results were, the full width at half maximum of the (102) plane was 433 arcsec, and the full width at half maximum of the (002) plane was 367 arcsec. No crack was observed on the entire surface of the wafer.

### (Embodiment 3)

As a silicon substrate, the epitaxial substrate shown in FIG. 1A in which misfit dislocations occurred was pre-annealed in a hydrogen atmosphere at 1120 °C, and then the epi layer was etched to a thickness of 1.5 µm by using HCl gas, and then processed similarly to the case as in Embodiment 1 to obtain a GaN on Si wafer. Among the GaN on Si wafers obtained, GaN layers (iGaN layer and AlGaN layer) were evaluated by an x-ray diffraction method. Results were: the full width at half maximum of the (102) plane was 568 arcsec, and the full width at half maximum of the (002) plane was 454 arcsec. No crack was found at the periphery of the wafer.

### (Comparison example 1)

GaN on Si wafers were obtained by proceeding processes similarly to the case as in Embodiment 1, except that the epitaxial substrate shown in FIG. 1B, in which misfit dislocations did not occur, was used as a silicon substrate. Among the GaN on Si wafers obtained, GaN layers (iGaN layer and AlGaN layer) were evaluated by an x-ray diffraction method. Results were: the full width at half maximum of the (102) plane was 447 arcsec, and the full width at half maximum of the (002) plane was 572 arcsec. Crack generation was observed also within about 20 mm from the outer periphery of the wafer.

### (Comparison example 2)

A 150-mmcp CZ polished wafer of 20 Qcm was used as a silicon substrate. Except for the substrate, processing was performed similarly to the case as in Embodiment 1 to obtain GaN on Si wafers. Among the GaN on Si wafers obtained, GaN layers (iGaN layer and AlGaN layer) were evaluated by an x-ray diffraction method. Results were: the full width at half maximum of the (102) plane was 641 arcsec, and the full width at half maximum of the (002) plane was 502 arcsec. Crack generation was observed also within about 20 mm from the outer periphery of the wafer.

Conditions of the silicon substrate, the full width at half maximum in XRD, and the states of crack generation for Embodiment 1, Embodiment 2, Embodiment 3, Comparison example 1, and Comparison example 2, are summarized in Table.

### [Table 1]

**TABLE 1**

| | Embodiment 1 | Embodiment 2 | Embodiment 3 | Comparison 1 | Comparison 2 |
|---|---|---|---|---|---|
| Si substrate | EP(P,T++) (MFD Occurred) | EP(P/P++) (MFD Occurred) | EP(P/P++) (MFD Occurred) | EP(P/P++) (No MFD) | PW(P-) (No MFD) |
| SiEP thickness | 6.0 *µ*m | 4.0 *µ*m | 1.5 *µ*m | 4.0 *µ*m | - |
| iGaN film thickness | 2500 nm | 2500 nm | 2500 nm | 2 500 nm | 2500 nm |
| XRD (002) | 318 | 367 | 454 | 447 | 502 |
| XRD (102) | 399 | 433 | 568 | 572 | 641 |
| Crack | No cracks | No cracks | No cracks | Occurred Outer periphery 20 mm | Occurred Outer periphery 20 mm |

certain depth so that plastic deformation is likely to occur therein, the generation of cracks is suppressed and the crystallinity of the epitaxial layer of the nitride semiconductor is improved. It can also be seen that, if the misfit layer is located closer to the interface at a distance to the interface about 1.5 µm or less, both of the good effects and adverse effects tend to be eliminated. There was no effect in suppressing the generation of cracks even when a silicon substrate doped with boron at a high concentration was used.

### DESCRIPTION OF REFERENCES

- 11:: Silicon epitaxial layer
- 12:: Silicon single crystal substrate (low resistant)
- 13:: Misfit dislocation
- 14:: Warpage of epitaxial wafer where misfit occurs
- 15:: Warpage of epitaxial wafer where misfit did not occur
- 33:: Initial layer
- 34:: AlN layer
- 35:: GaN layer
- 36:: Buffer layer
- 37:: Active (iGaN) layer
- 38:: Barrier layer
- 41:: Source electrode
- 42:: Drain electrode
- 43:: Gate electrode

## Claims

1. A semiconductor substrate in which a nitride semiconductor is epitaxially grown on a silicon single crystal substrate, wherein a misfit dislocation exists in the silicon single crystal substrate.

2. The semiconductor substrate according to claim 1, wherein a position at which the density of the misfit dislocation in a depth direction becomes the maximum is located at a positon more than 1.5 µm away from an interface between the silicon single crystal substrate and the nitride semiconductor.

3. A method for fabricating the semiconductor substrate according to claim 1 or 2, the method comprising steps of:
fabricating an epitaxial wafer by using a polished silicon wafer as a substrate, and vapor-depositing a silicon single crystal thin film on a main surface of the polished silicon wafer, the silicon single crystal thin film having a lattice constant different from that of the polished silicon wafer, a difference in the lattice constant causing a misfit dislocation at an interface with the substrate; and
epitaxially growing a nitride semiconductor by using the epitaxial wafer as the silicon single crystal substrate.

4. A method for fabricating the semiconductor substrate according to claim 1 or 2, the method comprising steps of:
when a silicon epitaxial layer is to be vapor-deposited on a polished silicon wafer, fabricating an epitaxial wafer by growing the epitaxial layer to sandwich an epitaxial layer having a lattice constant different from that of the epitaxial layer, thereby causing a misfit dislocation in the epitaxial layer due to a difference in the lattice constant; and
epitaxially growing a nitride semiconductor by using the epitaxial wafer as the silicon single crystal substrate.

5. A method for fabricating the semiconductor substrate according to claim 1 or 2, the method comprising steps of:
ion implanting one or more species of phosphorus, boron, antimony, carbon, or germanium into a polished silicon wafer to a high concentration;
performing a recovery heat treatment;
performing epitaxial growth by using the wafer as a substrate to cause a misfit dislocation at an interface with the substrate; and
epitaxially growing a nitride semiconductor by using the epitaxially grown wafer as the silicon single crystal substrate.
